(19) Europäisches Patentamt
European Patent Office
Office européen des brevets

(11) **EP 2 803 754 B1**

(12) **EUROPEAN PATENT SPECIFICATION**

(45) Date of publication and mention
of the grant of the patent:
**08.03.2017 Bulletin 2017/10**

(21) Application number: **12864833.4**

(22) Date of filing: **09.05.2012**

(51) Int Cl.:
*C23C 14/34* (2006.01)   *B21B 3/00* (2006.01)
*C22C 5/06* (2006.01)   *H01L 51/50* (2006.01)
*H05B 33/10* (2006.01)   *H05B 33/26* (2006.01)

(86) International application number:
**PCT/JP2012/061865**

(87) International publication number:
**WO 2013/105284 (18.07.2013 Gazette 2013/29)**

(54) **SILVER-ALLOY SPUTTERING TARGET FOR CONDUCTIVE-FILM FORMATION, AND METHOD FOR PRODUCING SAME**

SPUTTERTARGET AUS EINER SILBERLEGIERUNG ZUR HERSTELLUNG EINES LEITFÄHIGEN FILMS UND HERSTELLUNGSVERFAHREN DAFÜR

CIBLE DE PULVÉRISATION EN ALLIAGE D'ARGENT POUR LA FORMATION D'UN FILM CONDUCTEUR ET SON PROCÉDÉ DE PRODUCTION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **10.01.2012 JP 2012002072**

(43) Date of publication of application:
**19.11.2014 Bulletin 2014/47**

(73) Proprietor: **Mitsubishi Materials Corporation**
**Chiyoda-ku**
**Tokyo 100-8117 (JP)**

(72) Inventors:
• **KOMIYAMA, Shozo**
**Sanda-shi**
**Hyogo 669-1339 (JP)**
• **FUNAKI, Shinichi**
**Aizuwakamatsu-shi**
**Fukushima 965-8522 (JP)**
• **KOIKE, Shinya**
**Aizuwakamatsu-shi**
**Fukushima 965-8522 (JP)**
• **OKUDA, Sei**
**Sakai-shi**
**Osaka 590-0906 (JP)**

(74) Representative: **Hoffmann Eitle**
**Patent- und Rechtsanwälte PartmbB**
**Arabellastraße 30**
**81925 München (DE)**

(56) References cited:
EP-A1- 1 569 215        EP-A1- 1 659 194
EP-A1- 1 736 558        EP-A1- 2 233 604
EP-A1- 2 832 895        WO-A1-2011/043486
WO-A1-2011/078188       JP-A- 2004 002 929
JP-A- 2005 036 291      JP-A- 2005 314 717
JP-A- 2006 054 032      JP-A- 2011 162 876
US-A1- 2003 052 000     US-A1- 2004 226 818
US-A1- 2004 238 356

**Description**

TECHNICAL FIELD

The present invention relates to a silver-alloy sputtering target for conductive-film formation (for forming a conductive film) such as a reflective electrode in an organic EL element, a wiring film in a touch panel, and the like, and a method for producing the same.

BACKGROUND ART

In an organic EL element, holes and electrons are injected into an organic EL film from an anode and a cathode respectively by applying a voltage between the anode and the cathode formed on both sides of an organic EL light-emitting layer. Then, light is emitted when the holes and the electrons are combined together in the organic EL light-emitting layer. The organic EL element is a light-emitting element using the above-described light-emitting principle, and the organic EL element has been attracting significant attention in recent years for use in display devices. As a driving method of the organic EL element, there are a passive matrix and an active matrix. In the active matrix, one or more thin film transistors are provided in a pixel, and thus high-speed switching is possible. Therefore, the active matrix becomes advantageous in terms of an increase in the contrast ratio and an increase in the definition, and is a driving method capable of exhibiting the characteristics of the organic EL element.

In addition, as a light extraction (emission) system, there are a bottom emission system in which light is emitted from a transparent substrate side and a top emission system in which light is emitted from a side opposite to a substrate, and the top emission system having a high aperture ratio is advantageous in terms of an increase in the brightness.

A reflective electrode film in a top emission structure desirably has a high reflectivity and strong corrosion resistance so as to efficiently reflect light emitted from the organic EL layer. In addition, the reflective electrode film also desirably has a low resistance as an electrode. An Ag alloy and an Al alloy are known as materials having the above-described characteristics, and the Ag alloy is preferred due to its high reflectivity of visible light so as to obtain an organic EL element having a higher brightness. Here, a sputtering method is employed so as to form the reflective electrode film on the organic EL element, and a silver alloy target is used (Patent Document 1).

In response to an increase in the size of a glass substrate in the production of the organic EL element, a large silver alloy target has been used to form the reflective electrode film. Here, when a high electric power is supplied to a large target so as to carry out sputtering, a phenomenon called "splash" caused by the abnormal discharge of the target occurs. When this phenomenon occurs, molten fine particles are attached to the substrate such that wires or electrodes may be short-circuited. Thereby, there is a problem in that the yield of the organic EL element decreases. Since the reflective electrode layer in the organic EL element of the top emission system serves as a base layer for the organic light-emitting layer, there is a demand for greater flatness; and therefore, it is necessary to further suppress the splash.

In order to solve the above-described problem, Patent Documents 2 and 3 propose silver alloy targets for forming a reflective electrode film of the organic EL element capable of suppressing the splash even when a high electric power is supplied to the target in response to an increase in the size of the target and a method for producing the same.

The silver alloy targets for forming a reflective electrode film described in Patent Documents 2 and 3 have enabled the suppression of the splash even when a high electric power is supplied. However, in a large silver alloy target, there is a tendency that the number of times of arc discharging increases as the target is consumed and the splash caused by the arc discharging occurs more frequently; and therefore, there is a demand for further improvement.

In addition, studies are being conducted regarding the use of a silver alloy film in a conductive film such as a lead-out wiring in a touch panel in addition to the reflective electrode film for the organic EL element. However, the use of pure Ag as the wiring film causes migration; and thereby, the possibility of poor short-circuiting increases. Therefore, the employment of a silver alloy film is being studied.

PRIOR ART DOCUMENTS

Patent Documents

Patent Document1 : PCT International Publication No. WO 2002/077317
Patent Document 2: Japanese Unexamined Patent Application, First Publication No. 2011-100719
Patent Document 3: Japanese Unexamined Patent Application, First Publication No. 2011-162876

DISCLOSURE OF THE INVENTION

Problems to be Solved by the Invention

The present invention has been made in consideration of the above-described circumstances, and the present invention aims to provide a silver-alloy sputtering target for conductive-film formation capable of further suppressing arc discharging and the splash and a method for producing the same.

Means for Solving the Problems

As a result of intensive studies, the present inventors found out that, in order to suppress the increase in the number of times of arc discharging in response to the consumption of a target, it is effective to further refine crystal grains to an average grain diameter of less than 150 $\mu$m and to suppress the dispersion (variation) thereof within 20% or less of the average grain diameter.

Based on the above-described finding, a silver-alloy sputtering target for conductive-film formation of the invention has a component composition including In at a content in a range of 0.1 mass% to 1.5 mass% with a remainder of Ag and inevitable impurities, wherein an average grain diameter of crystal grains in an alloy is in a range of 30 $\mu$m or more to less than 150 $\mu$m, and a dispersion of grain diameters of the crystal grains is in a range of 20% or less of the average grain diameter.

In is solid-solubilized in Ag so as to suppress the crystal grain growth in the target; and therefore, In is effective for refining crystal grains. Since In improves the hardness of the target, In suppresses warpage during machining. In improves the corrosion resistance and the heat resistance of a film formed through sputtering. In the case where the content of In is less than 0.1 mass%, the above-described effects cannot be obtained, and in the case where the content of In exceeds 1.5 mass%, the reflectivity or the electric resistance of the film decreases.

The reason for setting the average grain diameter to be in a range of 30 $\mu$m or more to less than 150 $\mu$m will be described below. An average grain diameter of less than 30 $\mu$m is not realistic and causes an increase in the production costs. In addition, in the case where the average grain diameter is 150 $\mu$m or more, the number of times of occurring abnormal discharge tends to greatly increase in response to the consumption of the target during sputtering.

In the case where the dispersion of the average grain diameter exceeds 20%, the number of times of occurring abnormal discharge tends to greatly increase in response to the consumption of the target during sputtering.

The silver-alloy sputtering target for conductive-film formation of the invention has a component composition including In and Sn at a total content in a range of 0.1 mass% to 1.5 mass% with a remainder of Ag and inevitable impurities, wherein an average grain diameter of crystal grains in an alloy is in a range of 30 $\mu$m or more to less than 150 $\mu$m, and a dispersion of grain diameters of the crystal grains is in a range of 20% or less of the average grain diameter.

Similarly to In, Sn is solid-solubilized in Ag so as to suppress the crystal grain growth in the target; and therefore, Sn is effective for refining crystal grains. Since In and Sn improve the hardness of the target, In and Sn suppress warpage during machining. In and Sn improve the corrosion resistance and the heat resistance of a film formed through sputtering. In the case where the total content of In and Sn is less than 0.1 mass%, the above-described effects cannot be obtained, and, in the case where the total content of In and Sn exceeds 1.5 mass%, the reflectivity or the electric resistance of the film decreases.

The silver-alloy sputtering target for conductive-film formation of the invention has a component composition including: In at a content in a range of 0.1 mass% to 1.5 mass%; and either one or both of Sb and Ga at a total content in a range of 0.1 mass% to 2.5 mass%, with a remainder of Ag and inevitable impurities, wherein an average grain diameter of crystal grains in an alloy is in a range of 30 $\mu$m or more to less than 150 $\mu$m, and a dispersion of grain diameters of the crystal grains is in a range of 20% or less of the average grain diameter.

The silver-alloy sputtering target for conductive-film formation of the invention has a component composition including: In and Sn at a total content in a range of 0.1 mass% to 1.5 mass%; and either one or both of Sb and Ga at a total content in a range of 0.1 mass% to 2.5 mass%, with a remainder of Ag and inevitable impurities, wherein an average grain diameter of crystal grains in an alloy is in a range of 30 $\mu$m or more to less than 150 $\mu$m, and a dispersion of grain diameters of the crystal grains is in a range of 20% or less of the average grain diameter.

Sb and Ga are solid-solubilized in Ag so as to further suppress crystal grain growth. Sb and Ga further improve the corrosion resistance and the heat resistance of a film formed through sputtering. Particularly, Ga improves the resistance against chloridation of the film. In the case where the total content of Sb and Ga is less than 0.1 mass%, the above-described effect cannot be obtained. In the case where the total content of Sb and Ga exceeds 2.5 mass%, not only does the reflectivity or the electric resistance of the film decrease, but also cracking tends to occur during hot rolling.

The silver-alloy sputtering target for conductive-film formation of the invention, the average grain diameter of the crystal grains may be in a range of less than 120 $\mu$m.

In the case where the average grain diameter of the crystal grains is in a range of less than 120 $\mu$m, it is possible

to further suppress arc discharging and splash.

In a method for producing a silver-alloy sputtering target for conductive-film formation of the invention, a cast ingot having a component composition including In at a content in a range of 0.1 mass% to 1.5 mass% with a remainder of Ag and inevitable impurities is subjected to a hot rolling step, a cooling step and a machining step sequentially; and thereby, a silver-alloy sputtering target is produced. In the hot rolling step, one or more passes of finish hot rolling are carried out under conditions where a rolling reduction rate per pass is in a range of 20% to 50%, a strain rate is in a range of 3 /sec to 15 /sec, and a temperature after the pass is in a range of 400°C to 650°C, and in the cooling step, quenching is carried out at a cooling rate in a range of 200 °C/min to 1000 °C/min.

In the method for producing a silver-alloy sputtering target for conductive-film formation of the invention, a cast ingot having a component composition including In and Sn at a total content in a range of 0.1 mass% to 1.5 mass% with a remainder of Ag and inevitable impurities is subjected to a hot rolling step, a cooling step, and a machining step sequentially; and thereby, a silver-alloy sputtering target is produced. In the hot rolling step, one or more passes of finish hot rolling are carried out under conditions where a rolling reduction rate per pass is in a range of 20% to 50%, a strain rate is in a range of 3 /sec to 15 /sec, and a temperature after the pass is in a range of 400°C to 650°C, and in the cooling step, quenching is carried out at a cooling rate in a range of 200 °C/min to 1000 °C/min.

In the method for producing a silver-alloy sputtering target for conductive-film formation of the invention, a cast ingot having a component composition including: In at a content in a range of 0.1 mass% to 1.5 mass%; and either one or both of Sb and Ga at a total content in a range of 0.1 mass% to 2.5 mass%, with a remainder of Ag and inevitable impurities is subjected to a hot rolling step, a cooling step, and a machining step sequentially; and thereby, a silver-alloy sputtering target is produced. In the hot rolling step, one or more passes of finish hot rolling are carried out under conditions where a rolling reduction rate per pass is in a range of 20% to 50%, a strain rate is in a range of 3 /sec to 15 /sec, and a temperature after the pass is in a range of 400°C to 650°C, and in the cooling step, quenching is carried out at a cooling rate in a range of 200 °C/min to 1000 °C/min.

In the method for producing a silver-alloy sputtering target for conductive-film formation of the invention, a cast ingot having a component composition including: In and Sn at a total content in a range of 0.1 mass% to 1.5 mass%; and either one or both of Sb and Ga at a total content in a range of 0.1 mass% to 2.5 mass%, with a remainder of Ag and inevitable impurities is subjected to a hot rolling step, a cooling step, and a machining step sequentially; and thereby, a silver-alloy sputtering target is produced. In the hot rolling step, one or more passes of finish hot rolling are carried out under conditions where a rolling reduction rate per pass is in a range of 20% to 50%, a strain rate is in a range of 3 /sec to 15 /sec, and a temperature after the pass is in a range of 400°C to 650°C, and in the cooling step, quenching is carried out at a cooling rate in a range of 200 °C/min to 1000 °C/min.

The reason for setting the rolling reduction rate per pass of the finish hot rolling to be in a range of 20% to 50% will be described. In the case where the rolling reduction rate is less than 20%, crystal grains fail to be sufficiently refined. When an attempt is made to obtain a rolling reduction rate of more than 50%, the load of a rolling machine becomes excessive, which is not realistic.

In addition, the reason for setting the strain rate to be in a range of 3 /sec to 15 /sec will be described below. In the case where the strain rate is less than 3 /sec, crystal grains fail to be sufficiently refined, and mixed grains of fine grains and coarse grains tend to be generated. The strain rate exceeding 15 /sec makes the load of the rolling machine excessive; and therefore, this strain rate is not realistic.

In the case where the temperature after each pass is lower than 400°C, dynamic recrystallization becomes insufficient; and thereby, the dispersion of the crystal grain diameter tends to become greater. In the case where the temperature after each pass exceeds 650°C, crystal grains grow such that the average crystal grain diameter reaches 150 $\mu$m or more.

In addition, the quenching after the hot rolling suppresses the growth of the crystal grains; and thereby, a target having fine crystal grains can be obtained. In the case where a cooling rate is less than 200 °C/min, the effect of suppressing the growth of crystal grains is not sufficient. Even in the case where the cooling rate exceeds 1000 °C/min, there is no contribution to additional refinement.

Effects of the Invention

According to the invention, it is possible to obtain a target capable of further suppressing arc discharging and the splash even when a high electric power is supplied during sputtering, and it is possible to obtain a conductive film having a high reflectivity and excellent durability by sputtering the above-described target.

EMBODIMENTS OF THE INVENTION

Hereinafter, an embodiment of a silver-alloy sputtering target for conductive-film formation (for forming a conductive film) of the invention and a method for producing the same will be described. Meanwhile, "%" represents mass% unless particularly otherwise described or % represents the intrinsic unit of a numeric value.

In the target, the target surface (surface being subjected to sputtering of the target) has an area of 0.25 m² or more. In the case of a rectangular target, at least one side is 500 mm or more long, and the upper limit of the length is preferably 3000 mm from the viewpoint of the handling of the target. Meanwhile, the upper limit of the width is preferably 1700 mm from the viewpoint of the upper limit of the size that can be rolled in an ordinary rolling machine used in a hot rolling step. In addition, the thickness of the target is preferably in a range of 6 mm or more from the viewpoint of the exchange frequency of the target, and the thickness is preferably in a range of 25 mm or less from the viewpoint of the discharging stability of magnetron sputtering.

A silver-alloy sputtering target for conductive-film formation of a first embodiment is made of a silver alloy having a component composition including In at a content in a range of 0.1 mass% to 1.5 mass% with a remainder of Ag and inevitable impurities. The average grain diameter of crystal grains in the alloy is in a range of 30 μm or more to less than 150 μm, and the dispersion of the grain diameters of the crystal grains is in a range of 20% or less of the average grain diameter.

Ag has an effect of conferring a high reflectivity and a low resistance to a reflective electrode film in an organic EL element and a wiring film in a touch panel that are formed through sputtering.

In improves the hardness of the target; and therefore, In suppresses warpage during machining. Particularly, it is possible to suppress warpage during the machining of a large target which includes a target surface having an area of 0.25 m² or more. In addition, In has an effect of improving the corrosion resistance and the heat resistance of a reflective electrode film in an organic EL element formed through sputtering. The above-described effects are brought about by the following action. In refines crystal grains in a film, and In also decreases the surface roughness of the film. In addition, In is solid-solubilized in Ag so as to increase the strength of the crystal grains; and thereby, the coarsening of the crystal grains due to heat is suppressed. Therefore, In has effects of suppressing an increase in the surface roughness of a film and suppressing a decrease in the reflectivity due to corrosion of a film. Therefore, in a reflective electrode film or a wiring film formed using the silver-alloy sputtering target for conductive-film formation, the corrosion resistance and the heat resistance of the film are improved. Therefore, the silver-alloy sputtering target for conductive-film formation contributes to an increase in the brightness of an organic EL element and the reliability of wiring in a touch panel and the like.

The reason for limiting the content of In in the above-described range will be described. In the case where the content of In is less than 0.1 mass%, the above-described effects of the addition of In cannot be obtained. In the case where the content of In exceeds 1.5 mass%, the electric resistance of a film increases, or conversely, the reflectivity and the corrosion resistance of a film formed through sputtering decrease, which is not preferable. Therefore, since the composition of a film depends on the composition of the target, the content of In contained in the silver-alloy sputtering target is set to be in a range of 0.1 mass% to 1.5 mass%. The content of In is more preferably in a range of 0.2 mass% to 1.0 mass%.

A silver-alloy sputtering target for conductive-film formation of a second embodiment is made of a silver alloy having a component composition including In and Sn at a total content in a range of 0.1 mass% to 1.5 mass% with a remainder of Ag and inevitable impurities. The average grain diameter of crystal grains in the alloy is in a range of 30 μm or more to less than 150 μm, and the dispersion of the grain diameters of the crystal grains is in a range of 20% or less of the average grain diameter.

In the present embodiment, similarly to In, Sn is solid-solubilized in Ag so as to suppress the crystal grain growth in the target; and therefore, Sn is effective for refining crystal grains. Since In and Sn improve the hardness of the target, In and Sn suppress warpage during machining. In and Sn improve the corrosion resistance and the heat resistance of a film formed through sputtering. In the case where the total content of In and Sn is less than 0.1 mass%, the above-described effects cannot be obtained, and in the case where the total content of In and Sn exceeds 1.5 mass%, the reflectivity or the electric resistance of the film decreases.

A silver-alloy sputtering target for conductive-film formation of a third embodiment is made of a silver alloy having a component composition including: In at a content in a range of 0.1 mass% to 1.5 mass%; and either one or both of Sb and Ga at a total content in a range of 0.1 mass% to 2.5 mass%, with a remainder of Ag and inevitable impurities. The average grain diameter of crystal grains in the alloy is in a range of 30 μm or more to less than 150 μm, and the dispersion of the grain diameters of the crystal grains is in a range of 20% or less of the average grain diameter.

In addition, a silver-alloy sputtering target for conductive-film formation of a fourth embodiment is made of a silver alloy having a component composition including: In and Sn at a total content in a range of 0.1 mass% to 1.5 mass%; and either one or both of Sb and Ga at a total content in a range of 0.1 mass% to 2.5 mass%, with a remainder of Ag and inevitable impurities. The average grain diameter of crystal grains in the alloy is in a range of 30 μm or more to less than 150 μm, and the dispersion of the grain diameters of the crystal grains is in a range of 20% or less of the average grain diameter.

In the third and fourth embodiments, Sb and Ga are solid-solubilized in Ag so as to further suppress crystal grain growth. Sb and Ga further improve the corrosion resistance and the heat resistance of a film formed through sputtering. Particularly, Ga improves the resistance against chloridation of the film. In the case where a film formed through sputtering is used as a lead-out wiring film in a touch panel, the wiring film is required to have a resistance against a chlorine component contained in sweat from a human body because the touch panel is operated by the touch of a finger. A film having excellent resistance against chloridation can be formed by adding Ga.

In the case where the total content of Sb and Ga is less than 0.1 mass%, the above-described effects cannot be obtained. In the case where the total content of Sb and Ga exceeds 2.5 mass%, not only does the reflectivity or the electric resistance of the film decrease, but also cracking tends to occur during hot rolling.

In the above-described embodiments having the respective compositions, the average grain diameter of silver alloy crystal grains in the silver-alloy sputtering target is in a range of 30 $\mu$m or more to less than 150 $\mu$m, and preferably in a range of 30 $\mu$m or more to less than 120 $\mu$m. Regarding the average grain diameter of the silver alloy crystal grains, an average grain diameter of less than 30 $\mu$m is not realistic, and this causes an increase in the production cost. In addition, it is difficult to produce uniform crystal grains, and the dispersion of the grain diameters increases. Therefore, abnormal discharge is likely to occur during high-power sputtering, and splash is caused. On the other hand, in the case where the average grain diameter is 150 $\mu$m or more, as the target is consumed by a sputter, the unevenness of the sputter surface becomes large due to the difference in the sputter rate caused by the difference in crystal orientation among individual crystal grains. Therefore, abnormal discharge is likely to occur during high-power sputtering, and splash is likely to be caused. In the case where the average crystal grain diameter is set to be in a range of less than 120 $\mu$m, it is possible to further suppress arc discharging and splash.

Here, the average grain diameter of the silver alloy crystal grains is measured as described below.

Rectangular parallelepiped specimens approximately 10 mm on a side are sampled from 16 places at even intervals in a surface to be sputtered of the target. Specifically, the target is divided into 16 (4×4) segments, and a specimen is sampled from the central portion of each segment. Meanwhile, in the embodiment, since a surface to be sputtered having dimensions of 500 mm×500 mm or more, that is, a large target which includes the target surface having an area of 0.25 m$^2$ or more is taken into account, a method for sampling a specimen from a rectangular target normally used as a large target will be described. However, needless to say, the invention also exhibits an effect of suppressing the occurrence of splash in a round target. In this case, the surface to be sputtered of the target is evenly divided into 16 segments, and specimens are sampled according to the method for sampling a specimen from a large rectangular target.

Next, the surfaces to be sputtered of the respective specimens are polished. At this time, the polishing is carried out using water proof paper of #180 to #4000, and then buffing is carried out using abrasive grains having sizes of 3 $\mu$m to 1 $\mu$m.

Furthermore, the surfaces are etched until grain boundaries become visible using an optical microscope. Here, a mixed solution of hydrogen peroxide solution and ammonia water is used as an etching solution, the surfaces are immersed for one second to two seconds at room temperature; and thereby, the grain boundaries are made to appear. Next, photographs of the respective specimens are taken using the optical microscope at a magnification of 60 times to 120 times. Regarding the magnification of the photograph, a magnification facilitating the counting of crystal grains is selected.

On each photograph, a total of four 60 mm-long lines are drawn horizontally and perpendicularly in a grid shape (like # sign) at intervals of 20 mm, and the number of crystal grains intersected by the respective straight lines is counted. Meanwhile, a crystal grain on the edge of the line is counted as 0.5 grains. An average section length (L, $\mu$m) is obtained using L = 60000/(M·N) (here, M represents the actual magnification, and N represents the average value of the number of intersected crystal grains).

Next, the average grain diameter (d, $\mu$m) of the specimen is computed from the obtained average section length (L, $\mu$m) using d = (3/2)·L.

The average value of the average grain diameters of the specimens sampled from 16 places as described above is considered as the average grain diameter of silver alloy crystal grains in the target.

In the case where the dispersion of the grain diameter of the silver alloy crystal grains is in a range of 20% or less of the average grain diameter of the silver alloy crystal grains, splash during sputtering can be more reliably suppressed. Here, the dispersion of the grain diameter is computed as described below. Among the 16 average grain diameters obtained from 16 places, the average grain diameter having the greatest deviation in the absolute value (|[(the average grain diameter at a certain place) - (the average value of the average grain diameters at 16 places)]|) from the average value of the average grain diameters is specified. Next, the dispersion of the grain diameter is computed using the specified average grain diameter (specific average grain diameter) and the following formula.

$$\{ \mid [(\text{the specific average grain diameter}) - (\text{the average value of the average grain}$$

$$\text{diameters at 16 places})] \mid /(\text{the average value of the average grain diameters at 16}$$

$$\text{places})\} \times 100 \ (\%)$$

Next, a method for producing a silver-alloy sputtering target for conductive-film formation of the embodiment will be described.

In a method for producing a silver-alloy sputtering target for conductive-film formation of a first embodiment, Ag with a purity of 99.99 mass% or more and In with a purity of 99.9 mass% or more are used as raw materials.

First, Ag is melted in a high vacuum or inert gas atmosphere, and a predetermined content of In is added to the obtained molten silver. After that, the mixture is melted in a vacuum or inert gas atmosphere so as to manufacture a cast ingot of a silver alloy including In at a content in a range of 0.1 mass% to 1.5 mass% with a remainder of Ag and inevitable impurities.

Here, the melting of Ag and the addition of In are preferably carried out as described below. The atmosphere is once evacuated, and then, a vacuum atmosphere is replaced with argon gas, and Ag is melted in this atmosphere. Next, In is added to molten Ag in the argon atmosphere after the melting of Ag. Thereby, the composition ratio between Ag and In becomes stable.

In a method for producing a silver-alloy sputtering target for conductive-film formation of a second embodiment, Ag with a purity of 99.99 mass% or more, In and Sn having a purity of 99.9 mass% or more respectively are used as raw materials. In is melted in molten Ag, and Sn is added so that the total content of In and Sn becomes in a range of 0.1 mass% to 1.5 mass%. In this case as well, Ag is melted in a high vacuum or inert gas atmosphere, In and Sn are added at predetermined contents to the obtained molten silver, and then the mixture is melted in a vacuum or inert gas atmosphere.

In a method for producing a silver-alloy sputtering target for conductive-film formation of a third embodiment, Ag with a purity of 99.99 mass% or more and In, Sb, and Ga having a purity of 99.9 mass% or more respectively are used as raw materials. In at a content in a range of 0.1 mass% to 1.5 mass% and either one or both of Sb and Ga at a total content in a range of 0.1 mass% to 3.0 mass% are added to molten Ag. In this case as well, Ag is melted in a high vacuum or inert gas atmosphere, In, Sb and Ga are added at predetermined contents to the obtained molten silver, and then the mixture is melted in a vacuum or inert gas atmosphere.

In a method for producing a silver-alloy sputtering target for conductive-film formation of a fourth embodiment, Ag with a purity of 99.99 mass% or more and In, Sn, Sb, and Ga having a purity of 99.9 mass% or more respectively are used as raw materials. In and Sn at a total content in a range of 0.1 mass% to 1.5 mass% are added to molten Ag, and either one or both of Sb and Ga are further added at a total content in a range of 0.1 mass% to 3.0 mass%. In this case as well, Ag is melted in a high vacuum or inert gas atmosphere, In, Sn, Sb, and Ga are added at predetermined contents to the obtained molten silver, and then the mixture is melted in a vacuum or inert gas atmosphere.

In addition, the above-described melting and casting are desirably carried out in a vacuum or in an inert gas-substituted atmosphere, but it is also possible to use a melting furnace in air. In the case where a melting furnace in air is used, the melting and casting are carried out while blowing an inert gas to the surface of the molten silver alloy or covering the surface of the molten silver alloy with a carbon-based solid sealing material such as coal and the like. Thereby, it is possible to reduce the content of oxygen and non-metallic inclusions in the ingot.

The melting furnace is preferably an induction heating furnace for homogenizing the components.

In addition, it is efficient and desirable to carry out casting using a square casting mold to obtain a rectangular parallelepiped ingot, but it is also possible to cast a cylindrical ingot in a round casting mold and to work the cylindrical ingot to obtain a substantially rectangular parallelepiped ingot.

The obtained rectangular parallelepiped ingot is heated and hot-rolled to a predetermined thickness, and then the ingot is quenched.

In this case, the conditions of finish hot rolling in the final phase of hot rolling are important, and by setting the finish hot rolling conditions appropriately, it is possible to produce a silver alloy sheet having fine homogeneous crystal grains.

Specifically, in the finish hot rolling, the rolling reduction rate per pass is set to be in a range of 20% to 50%, the strain rate is set to be in a range of 3 /sec to 15 /sec, and the rolling temperature after each rolling pass is set to be in a range of 400°C to 650°C. One or more passes of this finish hot rolling are carried out. The total rolling reduction rate throughout the hot rolling is set to be, for example, in a range of 70% or more.

Here, the finish hot rolling refers to a rolling pass having a strong effect on the crystal grain diameter of a sheet material after rolling, includes the final rolling pass, and may be considered as three consecutive passes from the final rolling pass as necessary. After the final rolling, it is also possible to carry out additional rolling at a rolling reduction rate of 7% or less in the above-described rolling temperature range so as to adjust the sheet thickness.

In addition, the strain rate $\varepsilon$ (sec$^{-1}$) is considered to be expressed by the following formula.

[Formula 1]

$$\varepsilon = \frac{2\pi n}{60\sqrt{r'}} \cdot \sqrt{\frac{R}{H_0}} \cdot \ln\left(\frac{1}{1-r'}\right)$$

In the above-described formula, $H_0$ represents the sheet thickness (mm) on the inlet side of a rolling roll, n represents the rotation rate (rpm) of the rolling roll, R represents the radius (mm) of the rolling roll, r represents the rolling reduction rate (%), and r' = r/100.

In the case where the rolling reduction rate per pass is set to be in a range of 20% to 50% and the strain rate is set to be in a range of 3 /sec to 15 /sec, the ingot is strongly worked using a large energy at a relatively low temperature. Thereby, the mixture of coarse crystal grains is prevented, and it is possible to generate fine homogeneous crystal grains as a whole through dynamic recrystallization. In the case where the rolling reduction rate per pass is less than 20%, the crystal grains fail to be sufficiently refined. When an attempt is made to obtain a rolling reduction rate of more than 50%, the load of a rolling machine becomes excessive, which is not realistic. In addition, in the case where the strain rate is less than 3 /sec, crystal grains fail to be sufficiently refined, and mixed grains of fine grains and coarse grains tend to be generated. When an attempt is made to obtain a strain rate of more than 15 /sec, the load of the rolling machine becomes excessive, which is not realistic.

The rolling temperature after each pass is set to be in a range of 400°C to 650°C that is a low temperature for hot rolling. Thereby, the coarsening of the crystal grains is suppressed. In the cased where a rolling temperature is lower than 400°C, dynamic recrystallization becomes insufficient, and the dispersion of the crystal grain diameter tends to become greater. In the case where the rolling temperature exceeds 650°C, crystal grains grow, and the average crystal grain diameter becomes greater than 150 $\mu$m.

One pass of the final finish hot rolling is carried or multiple passes of the final finish hot rolling are carried as necessary.

The more preferable conditions of the finish hot rolling are as follows: a rolling reduction rate per pass is in a range of 25% to 50%; a strain rate is in a range of 5 /sec to 15 /sec; and a rolling temperature after the pass is in a range of 500°C to 600°C, and it is preferable to carry out three passes or more of the finish hot rolling.

Meanwhile, the rolling start temperature may not be in a range of 400°C to 650°C, and the rolling start temperature and the pass schedule are set so that the temperature after each pass becomes in a range of 400°C to 650°C in the finish hot rolling in the final phase.

In addition, after the above-described hot rolling step, quenching is carried out at a cooling rate in a range of 200 °C/min to 1000 °C/min from a temperature in a range of 400°C to 650°C to, for example, a temperature of 200°C or lower. The quenching suppresses the growth of crystal grains; and thereby, a rolled sheet including fine crystal grains can be obtained. In the case where the cooling rate is less than 200 °C/min, the effect of suppressing the growth of crystal grain is not sufficient. Even in the case where the cooling rate exceeds 1000 °C/min, there is no contribution to additional refinement. As a method of the quenching, the sheet may be showered using water for approximately one minute.

The rolled sheet obtained in the above-described manner is straightened using a straightening press, a roller leveler and the like, and then the rolled steel is subjected to machining such as milling or electrical discharge machining so as to be finished into desired dimensions. The arithmetic average roughness (Ra) of the sputter surface of the finally-obtained sputtering target is preferably in a range of 0.2 $\mu$m to 2 $\mu$m.

The silver-alloy sputtering target for conductive-film formation of the embodiment obtained in the above-described manner is capable of suppressing abnormal discharge and is also capable of suppressing the occurrence of splash even when a large power is supplied in the middle of sputtering. When this target is sputtered, a conductive film having a high reflectivity and excellent durability can be obtained. In addition, when sputtering is carried out using the silver-alloy sputtering target for conductive-film formation, it is possible to obtain a conductive film having favorable corrosion resistance and heat resistance and furthermore, having a low electric resistance. Particularly, the silver-alloy sputtering target for conductive-film formation is effective in the case of a large target having a target size of width: 500 mm, length: 500 mm and thickness: 6 mm or more.

EXAMPLES

(Example 1)

Ag with a purity of 99.99 mass% or more and In with a purity of 99.9 mass% or more as an additive raw material were prepared and loaded into a high-frequency induction melting furnace installed with a graphite crucible. The total mass during melting was set to approximately 1100 kg.

In the melting, Ag was first melted, and, after Ag was melted down, the additive raw material was added so as to obtain a target composition described in Table 1. The molten alloy was sufficiently stirred using the stirring effect of induction heating, and then the molten alloy was cast in a casting mold made of cast iron.

Shrink holes in the ingot obtained through the casting were removed, and the surface that had been in contact with the casting mold was ground and removed; and thereby, a rectangular parallelepiped ingot was obtained which included a sound part having approximate dimensions of 640×644×180 (mm).

The ingot was heated to 770°C, and the ingot was repeatedly rolled in a single direction so as to be stretched to have a length of 640 mm to 1700 mm. The stretched ingot was rotated by 90 degrees, and then rolling was repeatedly carried out in another 640 mm-long direction; and thereby, a sheet material was manufactured which had approximate dimensions of 1700×2100×20 (mm).

In the hot rolling, a total of 12 passes were repeated. Among those passes, the conditions for the three consecutive passes from the final pass (the strain rate per pass, the rolling reduction rate and the sheet material temperature after the pass) were set as described in Table 1. The total rolling reduction rate of the entire hot rolling was 89%.

After the end of the hot rolling, the sheet material after the rolling was cooled under the conditions described in Table 3.

After the cooling, the sheet material was passed through a roller leveler so as to straighten strains generated by the quenching, and the sheet material was machined to have dimensions of 1600×2000×15 (mm); and thereby, a target was manufactured.

(Examples 2 to 10 and Comparative Examples 1 to 10)

The heating temperature of an ingot before the hot rolling was changed in a range of 510°C to 880°C, the sheet thickness after the final rolling was changed in a range of 9.0 mm to 24.2 mm, the total number of the passes was changed in a range of 10 times to 14 times, the total rolling reduction rate was changed in a range of 87% to 95% in the same manner as in Example 1. In addition, a target was manufactured with the target composition described in Table 3 under the condition for the three consecutive passes from the final pass described in Table 1 and the condition of the cooling rate after the hot rolling described in Table 3. In Table 3, a target of which the cooling rate was described in the column of "Cooling rate" indicates a target which was cooled through water showering, and a target with "no water cooling" described in the column of "Cooling rate" indicates a target that was simply cooled in the air. However, the thickness of the target after machining was set to be in a range of 6 mm to 21 mm.

(Examples 11 to 13 and Comparative Example 11)

Raw materials were melted and cast in the same manner as in Example 1; and thereby, an ingot was manufactured which had approximate dimensions of 640×640×60 (mm). The ingot was heated to 700°C, and then the ingot was hot-rolled; and thereby, a sheet material was manufactured which had approximate dimensions of 1200×1300×16 (mm).

In the hot rolling, a total of six passes were repeated. Among those passes, the conditions for the three consecutive passes from the final pass (the strain rate per pass, the rolling reduction rate and the sheet material temperature after the pass) were set as described in Table 2. The total rolling reduction rate of the entire hot rolling was 73%.

After the end of the hot rolling, the sheet material after the rolling was cooled under the conditions described in Table 3.

After the cooling, the sheet material was passed through a roller leveler so as to straighten strains generated by the quenching, and the sheet material was machined to have dimensions of 1000×1200×12 (mm); and thereby, a target was manufactured.

(Example 14 and Comparative Example 12)

Ag with a purity of 99.99 mass% or more and In and Sn having purities of 99.9 mass% or more respectively as additive raw materials were prepared. In the high-frequency induction melting furnace installed with a graphite crucible, Ag was first melted, and, after Ag was melted down, the additive raw materials were added so as to obtain a target composition described in Table 3. The molten alloy was sufficiently stirred using the stirring effect of induction heating, and then the molten alloy was cast in a cast iron casting mold.

(Examples 15 to 22 and Comparative Example 13 to 15)

Ag with a purity of 99.99 mass% or more and In, Sb and Ga having purities of 99.9 mass% or more respectively as additive raw materials were prepared. In the high-frequency induction melting furnace installed with a graphite crucible, Ag was first melted, and, after Ag was melted down, the additive raw materials were added so as to obtain a target composition described in Table 3. The molten alloy was sufficiently stirred using the stirring effect of induction heating, and then the molten alloy was cast in a cast iron casting mold.

(Example 23)

Ag with a purity of 99.99 mass% or more and In, Sn, Sb and Ga having purities of 99.9 mass% or more respectively as additive raw materials were prepared. In the high-frequency induction melting furnace installed with a graphite crucible, Ag was first melted, and, after Ag was melted down, the additive raw materials were added so as to obtain a target composition described in Table 3. The molten alloy was sufficiently stirred using the stirring effect of induction heating, and then the molten alloy was cast in a cast iron casting mold.

In Examples 14 to 23 and Comparative Examples 12 to 15, after casting, an ingot having approximate dimensions of 640x640x60 (mm) was manufactured using an ingot obtained through casting in the same manner as in Examples 11 to 13 and Comparative Example 11. Next, the ingot was heated up to 700°C, and then the ingot was hot-rolled in the same manner as described above; and thereby, a sheet material was manufactured which had approximate dimensions of $1200 \times 1300 \times 16$ (mm).

In the hot rolling, a total of six passes were repeated. Among those passes, the conditions for the three consecutive passes from the final pass (the strain rate per pass, the rolling reduction rate and the sheet material temperature after the pass) were set as described in Table 2. The total rolling reduction rate of the entire hot rolling was 73%. Then, the sheet material was cooled under the conditions described in Table 3. Next, the sheet material was passed through a roller leveler so as to straighten strains generated by the quenching, and the sheet material was machined to have dimensions of $1000 \times 1200 \times 12$ (mm); and thereby, a target was manufactured.

Table 1

| | Finish hot rolling conditions | | | | | | | | |
| | Third pass from final rolling pass | | | Second pass from final rolling pass | | | Final rolling pass | | |
| | Strain rate (/sec) | Rolling reduction rate (%) | Temperature after pass (°C) | Strain rate (/sec) | Rolling reduction rate (%) | Temperature after pass (°C) | Strain rate (/sec) | Rolling reduction rate (%) | Temperature after pass (°C) |
|---|---|---|---|---|---|---|---|---|---|
| Comparative Example 1 | 2.1 | 19 | 510 | 2.5 | 20 | 490 | 2.8 | 20 | 470 |
| Example 1 | 5.0 | 26 | 570 | 5.7 | 25 | 540 | 8.5 | 36 | 510 |
| Example 2 | 2.2 | 21 | 530 | 2.6 | 23 | 500 | 3.0 | 23 | 480 |
| Example 3 | 2.8 | 17 | 550 | 3.4 | 21 | 520 | 4.2 | 24 | 500 |
| Example 4 | 3.7 | 23 | 490 | 4.3 | 24 | 470 | 5.1 | 25 | 450 |
| Example 5 | 3.9 | 10 | 610 | 8.6 | 33 | 580 | 14.8 | 50 | 550 |
| Comparative Example 2 | 5.5 | 30 | 380 | 6.6 | 30 | 360 | 8.0 | 31 | 350 |
| Example 6 | 4.4 | 23 | 440 | 5.6 | 27 | 420 | 7.2 | 31 | 400 |
| Example 7 | 5.0 | 26 | 550 | 6.9 | 33 | 530 | 8.3 | 32 | 510 |
| Example 8 | 5.2 | 28 | 600 | 6.9 | 33 | 580 | 8.4 | 33 | 550 |
| Example 9 | 5.3 | 25 | 650 | 6.6 | 28 | 630 | 9.3 | 36 | 600 |
| Comparative Example 3 | 2.9 | 21 | 730 | 3.4 | 23 | 700 | 3.8 | 23 | 670 |
| Comparative Example 4 | 3.2 | 17 | 540 | 3.6 | 18 | 520 | 4.0 | 18 | 500 |
| Example 10 | 5.1 | 20 | 540 | 5.8 | 21 | 520 | 6.5 | 21 | 500 |
| Comparative Example 5 | 4.9 | 22 | 650 | 6.6 | 29 | 630 | 7.8 | 29 | 600 |
| Comparative Example 6 | 4.9 | 26 | 630 | 6.4 | 30 | 610 | 8.2 | 33 | 580 |
| Comparative Example 7 | 2.0 | 17 | 500 | 2.2 | 17 | 470 | 2.4 | 16 | 450 |

EP 2 803 754 B1

11

(continued)

| | Finish hot rolling conditions | | | | | | | | |
|---|---|---|---|---|---|---|---|---|---|
| | Third pass from final rolling pass | | | Second pass from final rolling pass | | | Final rolling pass | | |
| | Strain rate (/sec) | Rolling reduction rate (%) | Temperature after pass (°C) | Strain rate (/sec) | Rolling reduction rate (%) | Temperature after pass (°C) | Strain rate (/sec) | Rolling reduction rate (%) | Temperature after pass (°C) |
| Comparative Example 8 | 4.6 | 15 | 360 | 5.2 | 17 | 350 | 6.0 | 18 | 330 |
| Comparative Example 9 | 2.0 | 24 | 720 | 2.3 | 24 | 690 | 2.7 | 25 | 660 |
| Comparative Example 10 | 5.2 | 24 | 630 | 6.4 | 27 | 610 | 7.6 | 28 | 580 |

Table 2

| | Finish hot rolling conditions | | | | | | | | |
| | Third pass from final rolling pass | | | Second pass from final rolling pass | | | Final rolling pass | | |
| | Strain rate (/sec) | Rolling reduction rate (%) | Temperature after pass ((°C) | Strain rate (/sec) | Rolling reduction rate (%) | Temperature after pass (°C) | Strain rate (/sec) | Rolling reduction rate (%) | Temperature after pass (°C) |
|---|---|---|---|---|---|---|---|---|---|
| Example 11 | 5.5 | 24 | 590 | 7.0 | 28 | 550 | 8.8 | 30 | 520 |
| Example 12 | 5.5 | 24 | 580 | 7.0 | 28 | 540 | 8.8 | 30 | 510 |
| Example 13 | 5.5 | 24 | 560 | 7.0 | 28 | 530 | 8.8 | 30 | 500 |
| Comparative Example 11 | 5.5 | 24 | 560 | 7.0 | 28 | 530 | 8.8 | 30 | 500 |
| Example 14 | 5.5 | 24 | 570 | 7.0 | 28 | 540 | 8.8 | 30 | 500 |
| Comparative Example 12 | 5.5 | 24 | 590 | 7.0 | 28 | 550 | 8.8 | 30 | 520 |
| Example 15 | 5.5 | 24 | 560 | 7.0 | 28 | 530 | 8.8 | 30 | 500 |
| Example 16 | 5.5 | 24 | 590 | 7.0 | 28 | 560 | 8.8 | 30 | 530 |
| Example 17 | 5.5 | 24 | 600 | 7.0 | 28 | 560 | 8.8 | 30 | 520 |
| Example 18 | 5.5 | 24 | 550 | 7.0 | 28 | 530 | 8.8 | 30 | 500 |
| Comparative Example 13 | 5.5 | 24 | 550 | 7.0 | 28 | 520 | 8.8 | 30 | 490 |
| Example 19 | 5.5 | 24 | 560 | 7.0 | 28 | 530 | 8.8 | 30 | 500 |
| Example 20 | 5.5 | 24 | 580 | 7.0 | 28 | 550 | 8.8 | 30 | 520 |
| Example 21 | 5.5 | 24 | 580 | 7.0 | 28 | 540 | 8.8 | 30 | 510 |
| Comparative Example 14 | 5.5 | 24 | 580 | 7.0 | 28 | 550 | 8.8 | 30 | 510 |
| Example 22 | 5.5 | 24 | 570 | 7.0 | 28 | 540 | 8.8 | 30 | 500 |
| Comparative Example 15 | 5.5 | 24 | 580 | 7.0 | 28 | 540 | 8.8 | 30 | 510 |
| Example 23 | 5.5 | 24 | 560 | 7.0 | 28 | 530 | 8.8 | 30 | 500 |

13

Table 3

| | Cooling rate (°C/min) | Target composition (mass%) | | | | |
|---|---|---|---|---|---|---|
| | | In | Sn | Sb | Ga | Ag |
| Comparative Example 1 | 300 | 0.7 | 0 | 0 | 0 | Remainder |
| Example 1 | 300 | 0.7 | 0 | 0 | 0 | Remainder |
| Example 2 | 300 | 0.7 | 0 | 0 | 0 | Remainder |
| Example 3 | 350 | 0.7 | 0 | 0 | 0 | Remainder |
| Example 4 | 300 | 0.7 | 0 | 0 | 0 | Remainder |
| Example 5 | 350 | 0.7 | 0 | 0 | 0 | Remainder |
| Comparative Example 2 | 300 | 0.5 | 0 | 0 | 0 | Remainder |
| Example 6 | 200 | 0.5 | 0 | 0 | 0 | Remainder |
| Example 7 | 350 | 0.5 | 0 | 0 | 0 | Remainder |
| Example 8 | 400 | 0.5 | 0 | 0 | 0 | Remainder |
| Example 9 | 400 | 0.5 | 0 | 0 | 0 | Remainder |
| Comparative Example 3 | 400 | 0.5 | 0 | 0 | 0 | Remainder |
| Comparative Example 4 | 300 | 0.6 | 0 | 0 | 0 | Remainder |
| Example 10 | 300 | 0.6 | 0 | 0 | 0 | Remainder |
| Comparative Example 5 | No water cooling | 0.6 | 0 | 0 | 0 | Remainder |
| Comparative Example 6 | 100 | 0.6 | 0 | 0 | 0 | Remainder |
| Comparative Example 7 | 300 | 0.6 | 0 | 0 | 0 | Remainder |
| Comparative Example 8 | 150 | 0.6 | 0 | 0 | 0 | Remainder |
| Comparative Example 9 | 400 | 0.6 | 0 | 0 | 0 | Remainder |
| Comparative Example 10 | 350 | 0 | 0 | 0 | 0 | Remainder |
| Example 11 | 350 | 0.2 | 0 | 0 | 0 | Remainder |
| Example 12 | 350 | 1 | 0 | 0 | 0 | Remainder |
| Example 13 | 350 | 1.5 | 0 | 0 | 0 | Remainder |
| Comparative Example 11 | 350 | 1.7 | 0 | 0 | 0 | Remainder |
| Example 14 | 350 | 0.5 | 0.5 | 0 | 0 | Remainder |
| Comparative Example 12 | 350 | 1 | 0.6 | 0 | 0 | Remainder |
| Example 15 | 350 | 0.5 | 0 | 0.1 | 0 | Remainder |
| Example 16 | 350 | 0.5 | 0 | 0.5 | 0 | Remainder |
| Example 17 | 350 | 0.5 | 0 | 1.5 | 0 | Remainder |
| Example 18 | 350 | 0.5 | 0 | 2.4 | 0 | Remainder |
| Comparative Example 13 | 350 | 0.5 | 0 | 2.7 | 0 | Remainder |
| Example 19 | 350 | 0.4 | 0 | 0 | 0.1 | Remainder |
| Example 20 | 350 | 0.4 | 0 | 0 | 1.5 | Remainder |
| Example 21 | 350 | 0.4 | 0 | 0 | 2.4 | Remainder |
| Comparative Example 14 | 350 | 0.4 | 0 | 0 | 2.7 | Remainder |
| Example 22 | 350 | 0.5 | 0 | 1.2 | 1.2 | Remainder |

(continued)

|  | Cooling rate (°C/min) | Target composition (mass%) | | | | |
|---|---|---|---|---|---|---|
|  |  | In | Sn | Sb | Ga | Ag |
| Comparative Example 15 | 350 | 0.5 | 0 | 1.4 | 1.3 | Remainder |
| Example 23 | 350 | 0.4 | 0.4 | 0.6 | 0.6 | Remainder |

With regard to the obtained targets, warpage after the machining, the average grain diameter, and the dispersion of the average grain diameter were measured. In addition, the target was installed in a sputtering device, and the number of times of occurring abnormal discharge during sputtering was measured. Furthermore, for conductive films obtained through sputtering, the surface roughness, the reflectivity, the resistance against chloridation and the specific resistance were measured.

(1) Warpage after the machining

The warpage amount per length of 1 m was measured in the silver-alloy sputtering target after the machining, and the result is described in Table 4.

(2) Average grain diameter and dispersion of the average grain diameter

The grain diameters of silver alloy crystal grains were measured using the method described in the EMBODIMENTS OF THE INVENTION section. In detail, specimens were sampled from 16 places at even intervals on the target produced in the above-described manner, and the average grain diameter in a surface visible to the sputtered surface of each specimen was measured. Then, the average grain diameter of silver alloy crystal grains that was an average value of the average grain diameters of the respective specimens and the dispersion of the average grain diameter of the silver alloy crystal grains were computed.

(3) Number of times of occurring abnormal discharge during sputtering

A round sheet having a diameter of 152.4 mm and a thickness of 6 mm was cut out from an arbitrary section of the target produced as described above, and the round sheet was soldered to a copper backing plate. The soldered target was used as a target for splash evaluation during sputtering, and the number of times of occurring abnormal discharge during sputtering was measured.

In this case, the soldered target was installed in an ordinary magnetron sputtering apparatus, and the air was exhausted until the pressure reached $1 \times 10^{-4}$ Pa. Next, sputtering was carried out under conditions where an Ar gas pressure was 0.5 Pa, a supplied power of DC was 1000 W and a distance between the target and the substrate was 60 mm. The number of times of occurring abnormal discharge occurring for 30 minutes from the beginning of the use of the target was measured. In addition, the target was consumed by continuously carrying out sputtering for 20 hours through the repetition of four-hour sputtering without a substrate and the exchange of an adhesion shield sheet. After that, sputtering was further carried out, and the number of times of occurring abnormal discharge occurring for 30 minutes after the consumption (20-hour sputtering) was measured. The number of times of occurring the abnormal discharge was measured using an arc counting function of a DC power generator (Model No. RPDG-50A) manufactured by MKS Instruments.

(4) Evaluation of the basic characteristics as a conductive film

(4-1) Surface roughness of the film

Sputtering was carried out under the same conditions as described above using the target for evaluation, and a silver alloy film having a film thickness of 100 nm was formed on a $20 \times 20$ (mm) glass substrate. Furthermore, in order to evaluate the heat resistance, the silver alloy film was subjected to a heat treatment at 250°C for 10 minutes. After that, the average surface roughness (Ra) of the silver alloy film was measured using an atomic force microscope.

(4-2) Reflectivity

A silver alloy film was formed on a $30 \times 30$ (mm) glass substrate in the same manner as described above. In addition, the absolute reflectivity of the silver alloy film at a wavelength of 550 nm was measured using a spectrophotometer.

Furthermore, in order to evaluate the corrosion resistance, the silver alloy film was held in a constant-temperature and high-humidity chamber having a temperature of 80°C and a humidity of 85% for 100 hours. After that, the absolute reflectivity of the silver alloy film at a wavelength of 550 nm was measured using a spectrophotometer.

(4-3) Resistance against chloridation

In order to check the effect of the addition of Ga, a silver alloy film was formed in the same manner as described above using a Ga-added target (Examples 19 to 23 and Comparative Examples 14 and 15). Next, an aqueous solution containing 5% by weight of NaCl was sprayed to the film surface of the silver alloy film. The aqueous solution was sprayed in a direction parallel to the film surface from a location 20 cm high from the film surface and 10 cm distant from the edge of the substrate, and the NaCl aqueous solution sprayed on the film was left to fall freely as much as possible and be attached to the film. The aqueous solution was sprayed five times every one minute, and then th e film was washed using pure water three times. Moisture was blown off by spraying dried air, and the film was dried.

The silver alloy film surface after the above-described spraying of saline water was visually observed, and the state of the surface was evaluated. Regarding the evaluation criteria of the resistance against chloridation, a film surface which did not become white-turbid or spotted or became only partially white-turbid or spotted was evaluated to be "favorable", and a film surface which became fully white-turbid or spotted was evaluated to be "poor". The surface state was evaluated into two levels using the above-described criteria. For the target to which Ga had not been added, no evaluation was carried out, and thus "-" was marked in the table.

(4-4) Specific resistance of the film

The specific resistance of the silver alloy film formed in the same manner as described above was measured.

The respective evaluation results are described in Tables 4 to 6.

Table 4

| | Average grain diameter ($\mu$m) | Dispersion of grain diameter (%) | Warpage after machining (mm) | Number of times of abnormal discharge (times) | |
| --- | --- | --- | --- | --- | --- |
| | | | | At the beginning of use | After consumption |
| Comparative Example 1 | 180 | 23 | 0.6 | 5 | 12 |
| Example 1 | 80 | 13 | 0.5 | 0 | 0 |
| Example 2 | 140 | 19 | 0.5 | 3 | 6 |
| Example 3 | 130 | 18 | 0.6 | 1 | 3 |
| Example 4 | 90 | 15 | 0.7 | 0 | 1 |
| Example 5 | 60 | 14 | 0.4 | 0 | 0 |
| Comparative Example 2 | 70 | 35 | 0.7 | 10 | 38 |
| Example 6 | 90 | 18 | 0.6 | 1 | 2 |
| Example 7 | 100 | 14 | 0.6 | 1 | 1 |
| Example 8 | 110 | 13 | 0.5 | 0 | 0 |
| Example 9 | 140 | 13 | 0.5 | 1 | 4 |
| Comparative Example 3 | 170 | 11 | 0.4 | 2 | 12 |
| Comparative Example 4 | 190 | 25 | 0.7 | 5 | 15 |

(continued)

| | Average grain diameter (μm) | Dispersion of grain diameter (%) | Warpage after machining (mm) | Number of times of abnormal discharge (times) | |
|---|---|---|---|---|---|
| | | | | At the beginning of use | After consumption |
| Example 10 | 140 | 18 | 0.7 | 3 | 4 |
| Comparative Example 5 | 190 | 14 | 0.6 | 2 | 12 |
| Comparative Example 6 | 170 | 15 | 0.5 | 3 | 12 |
| Comparative Example 7 | 210 | 29 | 0.6 | 13 | 46 |
| Comparative Example 8 | 170 | 44 | 0.5 | 15 | 61 |
| Comparative Example 9 | 250 | 14 | 0.7 | 2 | 23 |
| Comparative Example 10 | 160 | 15 | 2.8 | 2 | 13 |
| Example 11 | 140 | 18 | 1.2 | 3 | 4 |
| Example 12 | 120 | 15 | 0.6 | 0 | 1 |
| Example 13 | 90 | 14 | 0.6 | 1 | 0 |
| Comparative Example 11 | 80 | 14 | 0.6 | 0 | 0 |
| Example 14 | 90 | 14 | 0.6 | 0 | 1 |
| Comparative Example 12 | 80 | 15 | 0.5 | 1 | 0 |
| Example 15 | 60 | 16 | 0.5 | 1 | 0 |
| Example 16 | 50 | 16 | 0.6 | 0 | 0 |
| Example 17 | 45 | 18 | 0.6 | 1 | 1 |
| Example 18 | 35 | 18 | 0.8 | 1 | 1 |
| Comparative Example 13 | 35 | 18 | Cracked | 1 | 1 |
| Example 19 | 60 | 17 | 0.6 | 0 | 0 |
| Example 20 | 50 | 18 | 0.5 | 0 | 0 |
| Example 21 | 45 | 17 | 0.8 | 0 | 0 |
| Comparative Example 14 | 35 | 17 | Cracked | 0 | 1 |
| Example 22 | 40 | 18 | 0.7 | 0 | 1 |
| Comparative Example 15 | 40 | 18 | Cracked | 1 | 0 |
| Example 23 | 50 | 18 | 0.6 | 0 | 0 |

Table 5

| | Absolute reflectivity of film (%) | Specific resistance of film ($\mu\Omega\cdot$cm) | Absolute reflectivity after holding of film at constant temperature and constant humidity (%) | Evaluation of resistance against chloridation of film | Surface roughness after heat treatment of film Ra (nm) |
|---|---|---|---|---|---|
| Comparative Example 1 | 96.6 | 4.4 | 96.4 | - | 0.8 |
| Example 1 | 96.6 | 4.3 | 96.5 | - | 0.9 |
| Example 2 | 96.7 | 4.3 | 96.5 | - | 0.8 |
| Example 3 | 96.5 | 4.4 | 96.4 | - | 0.9 |
| Example 4 | 96.7 | 4.4 | 96.4 | - | 0.9 |
| Example 5 | 96.5 | 4.3 | 96.4 | - | 0.8 |
| Comparative Example 2 | 96.9 | 4.1 | 96.7 | - | 0.9 |
| Example 6 | 96.8 | 4.1 | 96.7 | - | 0.9 |
| Example 7 | 96.8 | 4.2 | 96.6 | - | 0.8 |
| Example 8 | 96.7 | 4.1 | 96.6 | - | 0.9 |
| Example 9 | 96.8 | 4.1 | 96.6 | - | 0.9 |
| Comparative Example 3 | 96.8 | 4.2 | 96.5 | | 0.9 |
| Comparative Example 4 | 96.6 | 4.3 | 96.4 | - | 0.8 |
| Example 10 | 96.7 | 4.2 | 96.5 | - | 0.9 |
| Comparative Example 5 | 96.6 | 4.3 | 96.4 | - | 0.8 |
| Comparative Example 6 | 96.7 | 4.2 | 96.4 | - | 0.8 |
| Comparative Example 7 | 96.6 | 4.3 | 96.3 | - | 0.9 |
| Comparative Example 8 | 96.7 | 4.3 | 96.5 | - | 0.8 |
| Comparative Example 9 | 96.6 | 4.2 | 96.4 | - | 0.9 |
| Comparative Example 10 | 97.6 | 3.2 | 89.7 | - | 2.3 |

Table 6

| | Absolute reflectivity of film (%) | Specific resistance of film ($\mu\Omega\cdot$cm) | Absolute reflectivity after holding of film at constant temperature and constant humidity (%) | Evaluation of resistance against chloridation of film | Surface roughness after heat treatment of film Ra (nm) |
|---|---|---|---|---|---|
| Example 11 | 97.1 | 3.6 | 96.2 | - | 1.2 |
| Example 12 | 95.9 | 4.6 | 95.5 | - | 0.7 |

(continued)

|  | Absolute reflectivity of film (%) | Specific resistance of film ($\mu\Omega\cdot$cm) | Absolute reflectivity after holding of film at constant temperature and constant humidity (%) | Evaluation of resistance against chloridation of film | Surface roughness after heat treatment of film Ra (nm) |
|---|---|---|---|---|---|
| Example 13 | 95.5 | 5.9 | 95.0 | - | 0.7 |
| Comparative Example 11 | 92.9 | 7.5 | 86.5 | - | 0.7 |
| Example 14 | 96.2 | 4.6 | 95.9 | - | 0.8 |
| Comparative Example 12 | 91.3 | 7.5 | 88.3 | - | 0.7 |
| Example 15 | 96.8 | 4.4 | 96.6 | - | 0.7 |
| Example 16 | 96.6 | 5.2 | 94.4 | - | 0.6 |
| Example 17 | 95.0 | 6.4 | 94.0 | - | 0.5 |
| Example 18 | 94.5 | 6.9 | 93.5 | - | 0.5 |
| Comparative Example 13 | 92.1 | 8.8 | 88.1 | - | 0.5 |
| Example 19 | 96.7 | 4.4 | 96.4 | Favorable | 0.7 |
| Example 20 | 94.9 | 6.8 | 91.8 | Favorable | 0.6 |
| Example 21 | 93.8 | 7.2 | 90.5 | Favorable | 0.6 |
| Comparative Example 14 | 91.3 | 10.2 | 83.9 | Favorable | 0.5 |
| Example 22 | 93.9 | 7.1 | 91.0 | Favorable | 0.6 |
| Comparative Example 15 | 91.1 | 10.5 | 84.3 | Favorable | 0.5 |
| Example 23 | 94.8 | 6.7 | 93.5 | Favorable | 0.6 |

In the target materials of the examples, the average grain diameters of the silver alloy crystal grains were in a range of 30 $\mu$m or more to less than 150 $\mu$m, and the dispersions of the grain diameters of the silver alloy crystal grains were in a range of 20% or less of the average grain diameters of the silver alloy crystal grains. The warpage after machining was small, and the number of times of occurring abnormal discharge during sputtering was also small not only at the beginning of the use of the target but also after the consumption of the target. Particularly, in the case where the average crystal grain diameter was in a range of 120 $\mu$m or less and the dispersion of the grain diameter was in a range of 20% or less, the number of times of occurring abnormal discharge was one or less which was small in all the examples except for Example 6 in which the number was two after the consumption. In addition, the targets to which Sb and Ga were added tended to have a small average crystal grain diameter and had a small number of times of occurring abnormal discharge that was one or less. However, in the target in which the addition amount of Sb and Ga was excessive (greater than 2.5 mass% in total), cracking occurred during the machining.

In addition, in the conductive films obtained using the target material of the examples, the reflectivity and the specific resistance were excellent, and the surface roughness Ra was also as small as 2 $\mu$m or less.

In addition, it was found that the conductive films obtained using the Ga-added target also had excellent resistance against chloridation, and was effective for a conductive film in a touch panel or the like.

Industrial Applicability

When the target of the embodiment is sputtered, the occurrence of arc discharging and splash is suppressed. In addition, a conductive film obtained by sputtering the target of the embodiment has an excellent reflectivity and excellent resistivity, and also has a small surface roughness. Therefore, the target of the embodiment is preferably applicable as a target for forming a conductive film such as a reflective electrode layer in an organic EL element or a wiring film in a touch panel.

**Claims**

1. A silver-alloy sputtering target for conductive-film formation having a component composition comprising:

   (i) In, which is an element solid-solubilized in Ag, at a content in a range of 0.1 mass% to 1.5 mass% or (ii) In and Sn, which are elements solid-solubilized in Ag, at a total content in a range of 0.1 mass% to 1.5 mass%; and optionally either one or both of Sb and Ga, which are elements solid-solubilized in Ag, at a total content in a range of 0.1 mass% to 2.5 mass%,
   with a remainder of Ag and inevitable impurities,
   wherein an average grain diameter of crystal grains in an alloy is in a range of 30 $\mu$m or more to less than 150 $\mu$m, and a dispersion of grain diameters of the crystal grains is in a range of 20% or less of the average grain diameter.

2. The silver-alloy sputtering target for conductive-film formation according to Claim 1,
   wherein the average grain diameter of the crystal grains is in a range of less than 120 $\mu$m.

3. A method for producing a silver-alloy sputtering target for conductive-film formation,
   the method comprising: subjecting a cast ingot to a hot rolling step, a cooling step, and a machining step sequentially, thereby producing a silver-alloy sputtering target,
   wherein in the hot rolling step, one or more passes of finish hot rolling are carried out under conditions where a rolling reduction rate per pass is in a range of 20% to 50%, a strain rate is in a range of 3 /sec to 15 /sec, and a temperature after the pass is in a range of 400°C to 650°C,
   in the cooling step, quenching is carried out at a cooling rate in a range of 200°C/min to 1000 °C/min, and the cast ingot has a component composition including:

   (i) In at a content in a range of 0.1 mass% to 1.5 mass% or (ii) In and Sn at a total content in a range of 0.1 mass% to 1.5 mass%; and
   optionally either one or both of Sb and Ga at a total content in a range of 0.1 mass% to 2.5 mass%,
   with a remainder of Ag and inevitable impurities.

**Patentansprüche**

1. Silberlegierungssputtertarget zur Ausbildung leitfähiger Filme mit einer Komponentenzusammensetzung, die aufweist:

   (i) In, das ein Element ist, das im Festlösungszustand in Ag gelöst ist, mit einem Gehalt in einem Bereich von 0,1 Masse-% bis 1,5 Masse-% oder (ii) In und Sn welches Elemente sind, die im Festlösungszustand in Ag gelöst sind, mit einem Gesamtgehalt in einem Bereich von 0,1 Masse-% bis 1,5 Masse-%; und optional entweder eines oder beides aus Sb und Ga, welches Elemente sind, die im Festlösungszustand in Ag gelöst sind, mit einem Gesamtgehalt in einem Bereich von 0,1 Masse-% bis 2,5 Masse-%,
   mit einem Rest der Silber ist und unvermeidbaren Verunreinigung,
   wobei ein mittlerer Korndurchmesser von Kristallkörnern in einer Legierung in einem Bereich von 30 $\mu$m oder mehr oder weniger als 150 $\mu$m fällt und eine Verteilung von Durchmessern der Kristallkörner in einem Bereich von 20 % oder weniger des mittleren Korndurchmessers fällt.

2. Silberlegierungssputtertarget für die Ausbildung leitfähiger Filme gemäß Anspruch 1,
   wobei der mittlere Korndurchmesser der Kristallkörner in einem Bereich von weniger als 120 $\mu$m fällt.

3. Verfahren zum Herstellen eines Silberlegierungssputtertargets für die Ausbildung leitfähiger Filme,
   wobei das Verfahren aufweist: Unterziehen eines Gussblocks eines Warmwalzschrittes, eines Kühlschrittes und eines Bearbeitungsschrittes sequenziell wodurch ein Silberlegierungssputtertarget produziert wird,
   wobei in dem Warmwalzschritt ein oder mehrere Durchläufe eines Fertigwarmwalzens unter Bedingungen ausgeführt werden in denen eine Walzreduktionsrate pro Durchlauf in einem Bereich von 20% bis 50% liegt, eine Dehnungsrate in einem Bereich von 3/s bis 15/s und eine Temperatur nach dem Durchlauf in einem Bereich von 400°C bis 650°C liegt,

in dem Kühlschritt eine Abschreckung mit einer Kühlrate in einem Bereich von 200°C/min bis 1000°C/min durchgeführt wird, und

der Gussblock eine Komponentenzusammensetzung aufweist, die aufweist:

(i) In mit einem Gehalt in einem Bereich von 0,1 Massen-% bis 1,5 Masse-% oder (ii) In und Sn mit einem Gesamtgehalt in einem Bereich von 0,1 Masse-% bis 1,5 Masse-%; und

optional entweder eines oder beides aus Sb und Ga mit einem Gesamtgehalt in einem Bereich von 0,1 Masse-% bis 2,5 Masse-%,

mit einem Rest der Silber ist und unvermeidbaren Verunreinigungen.

**Revendications**

1. Cible de pulvérisation cathodique en alliage d'argent pour une formation de film conducteur ayant une composition de constituants comprenant :

(i) In, qui est un élément solubilisé à l'état solide dans Ag, à une teneur dans une plage de 0,1 % en masse à 1,5 % en masse ou (ii) In et Sn, qui sont des éléments solubilisés à l'état solide dans Ag, à une teneur totale dans une plage de 0,1 % en masse à 1,5 % en masse ; et

de manière facultative l'un ou l'autre de Sb et Ga ou les deux, qui sont des éléments solubilisés à l'état solide dans Ag, à une teneur totale dans une plage de 0,1 % en masse à 2,5 % en masse,

avec un reste d'Ag et d'impuretés inévitables,

dans lequel un diamètre de grain moyen de grains cristallins dans un alliage est dans une plage de 30 $\mu$m ou plus à moins de 150 $\mu$m, et une dispersion de diamètres de grain des grains cristallins est dans une plage de 20 % ou moins du diamètre de grain moyen.

2. Cible de pulvérisation cathodique en alliage d'argent pour une formation de film conducteur selon la revendication 1, dans laquelle le diamètre de grain moyen des grains cristallins est dans une plage de moins de 120 $\mu$m.

3. Procédé pour produire une cible de pulvérisation cathodique en alliage d'argent pour une formation de film conducteur,

le procédé comprenant : la soumission d'un lingotin de coulée à une étape de laminage à chaud, une étape de refroidissement et une étape d'usinage de manière séquentielle, en produisant de ce fait une cible de pulvérisation cathodique en alliage d'argent,

dans lequel dans l'étape de laminage à chaud, une ou plusieurs passes de laminage à chaud de finition sont effectuées sous des conditions où un taux de réduction de laminage par passe est dans une plage de 20 % à 50 %, une vitesse de déformation est dans une plage de 3 /s à 15 /s, et une température après la passe est dans une plage de 400 °C à 650 °C,

dans l'étape de refroidissement, une trempe est effectuée à une vitesse de refroidissement dans une plage de 200 °C/min à 1000 °C/min, et

le lingotin de coulée a une composition de constituants incluant :

(i) In à une teneur dans une plage de 0,1 % en masse à 1,5 % en masse ou (ii) In et Sn à une teneur totale dans une plage de 0,1 % en masse à 1,5 % en masse ; et

de manière facultative l'un ou l'autre de Sb et Ga ou les deux à une teneur totale dans une plage de 0,1 % en masse à 2,5 % en masse,

avec un reste d'Ag et d'impuretés inévitables.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2002077317 A
- JP 2011100719 A
- JP 2011162876 A